# EUROPÄISCHE PATENTSCHRIFT

(11) **EP 3 900 120 B1**
(45) Veröffentlichungstag und Bekanntmachung des Hinweises auf die Patenterteilung: **04.10.2023**
(21) Anmeldenummer: 19827650.3
(22) Anmeldetag: 11.12.2019
(51) Int. Cl.: H01R 13/447, H01R 13/70, B60L 50/64, B60L 3/04

(54) **HOCHVOLT-VORRICHTUNG**
HIGH-VOLTAGE DEVICE
DISPOSITIF À HAUTE TENSION

(30) Priorität: 17.12.2018 DE 102018221907; 12.03.2019 DE 102019203296
(43) Veröffentlichungstag der Anmeldung: 27.10.2021
(73) Patentinhaber: Robert Bosch GmbH, 70442 Stuttgart (DE)
(72) Erfinder: MAIBRINK, Thomas, 72813 St. Johann Gaechingen (DE)
(86) Internationale Anmeldenummer: PCT/EP2019/084563
(87) Internationale Veröffentlichungsnummer: WO 2020/126723

(56) Entgegenhaltungen:
- EP-A1- 3 026 763

## Beschreibung

Die vorliegende Erfindung betrifft eine Hochvolt-Vorrichtung für eine Hochvoltanwendung.

Aktuelle Hochvolt-Systeme (Leistungselektronik, Hochvolt-Batterie, E-Motor, ...) im Automobilbereich werden mittels Sicherheitssystemen wie zum Beispiel Berührschutzmaßnahmen und Abschaltsystemen abgesichert.

### Stand der Technik

In der DE 10 2014 012 320 B3 ist ein Batteriemodul offenbart, wobei das Batteriemodul ein den elektrischen Pol elektrisch isolierendes Gehäuse umfasst, durch welches ein Berührschutz für die Schraube und den elektrischen Pol bereitgestellt ist.

Aus der EP 3 026 763 A1 ist eine elektrische Vorrichtung mit einem Stromkreis bekannt. Um einen direkten Zugriff auf den Stromkreis zu vermeiden und einen Bediener vor einem elektrischen Schock zu schützen, ist ein Deckel über dem Stromkreis angeordnet. Zusätzlich wird über einen Sicherheitsschalter, der vor dem Entfernen des Deckels herausgedreht werden muss, gewährleistet, dass der Stromkreis unterbrochen wird. Erst nach dem Herausdrehen des Sicherheitsschalters kann eine letzte, den Deckel haltende, Schraube entfernt werden. Während dieser Zeit kann der Stromkreis entladen werden.

Eines der gängigen Systeme ist mittels einer elektrischen Schleife alle abnehmbaren Teile (z.B. Stecker und Deckel) abzufragen und bei entsprechender Unterbrechung dieser Abfrageschleife die Hochvoltsicherheitsrelevanten Bereiche abzuschalten und spannungsfrei zu machen. In vielen Erzeugnissen erfolgt dies mittels zweier zusätzlicher Pins eines bestehenden Steckers (z. B. Fahrzeugsignalstecker oder Abgriff Klimakompressor). Deckel oder andere abnehmbare Teile weisen eine mechanische Kulisse vor, die ein Abnehmen des Deckels vor Ziehen des Steckers verhindert. Somit wird vor Öffnen des/der Deckel dieser Stecker vorab abgezogen und die Entladung des gesamten Systems erfolgt.

Der Hintergrund der Erfindung ist, dass bei bestehenden Systemen eine zusätzliche Steckerschnittstelle benötigt wird, um den zeitlichen Versatz zwischen Öffnen Hochvolt-Interlock-Leitung und Zugang zu Hochvolt-Anschlüssen zu ermöglichen. Bei Systemen die keine elektrische Schnittstelle vorweisen, in die die Hochvolt-Interlock-Abfrage integriert werden kann, ist die Hochvolt-Sicherheits-Entladezeit meist nicht oder nur sehr umständlich realisiert.

Es ist daher die Aufgabe der vorliegenden Erfindung eine Hochvolt-Vorrichtung anzugeben, mit welcher bei Systemen die keine elektrische Schnittstelle vorweisen, auf einfache Weise eine sichere Entladezeit gewährleistet werden kann.

### Offenbarung der Erfindung

Die Aufgabe wird durch eine Hochvolt-Vorrichtung mit den Merkmalen nach Anspruch 1 gelöst. Die Erfindung wird durch die in Anspruch 1 spezifizierten Merkmale definiert. Die jeweils rückbezogenen abhängigen Ansprüche geben vorteilhafte Weiterbildungen der Erfindung wieder.

Die Erfindung gibt eine Hochvolt-Vorrichtung für eine Hochvoltanwendung an. Die Hochvolt-Vorrichtung umfasst dabei ein elektrisch isolierendes Gehäuse mit einem ein Gehäuseinneres abdeckenden Gehäusedeckel und im Gehäuseinneren angeordnete Abdeckmittel für wenigstens eine vor Berührung zu schützende elektrische Anschlussklemme oder elektrischen Bereich.

Die Abdeckmittel weisen einen die elektrische Anschlussklemme oder den elektrischen Bereich abdeckenden Schutzdeckel auf, der durch mindestens ein Sperrelement in einer geschlossenen Position arretierbar ist und durch einen Öffnungsvorgang in eine geöffnete Position überführbar ist, wobei das mindestens eine Sperrelement für den gehäuseinneren Schutzdeckel derart ausgebildet ist, dass dessen Lösen eine Zeitdauer beansprucht, nach welcher ab dem Öffnen des Gehäusedeckels und damit ausgelöster Unterbrechung des Hochvolt-Stromkreises die elektrische Anschlussklemme oder der elektrische Bereich in einen berührungssicheren Zustand übergegangen ist.

Unter Hochvolt im Sinne der Erfindung wird die entsprechende im Automobilsektor verwendete Bezeichnung verstanden, bei welcher die Spannung oberhalb 60V ist.

Als Abdeckmittel wird dabei ein Element verstanden, dessen Material, Form und Ausgestaltung entsprechend des benötigten Schutzes gewählt ist. Als Sperrelement wird dabei ein Bauteil verstanden, welches ein direktes Öffnen verhindert. Dies bedeutet, dass das Sperrelement bei üblicher Handhabung zuerst entsperrt werden muss, bevor ein Zugang zu der zu schützenden elektrischen Anschlussklemme und/oder ein Bereich möglich ist. Die Deaktivierung, d.h. das Entsperren des wenigstens einen Sperrelementes benötigt dabei in der Regel eine Mindestzeit, die notwendig ist, so dass die elektrische Anschlussklemme nicht mehr geschützt werden muss.

Das Abdeckmittel hat somit den Vorteil, dass nach Auslösen eines ersten Ereignisses, wie beispielsweise Unterbrechen der Stromversorgung, nachdem eine zu schützende elektrische Anschlussklemme eine vorbestimmte Zeit weiterhin vor Berührung und/oder vor Eingriff geschützt werden muss, diese vorbestimmte Zeit wenigstens gewährleistet werden kann. Diese Zeit wird dabei durch eine Zeitfunktion gewährleitstet, die benötigt wird, um das wenigstens eine Sperrelement des Abdeckmittels zu entsperren. Dadurch wird eine sichere Anwendung für den Benutzer ermöglicht. Dadurch kann eine ausreichende Entladezeit auf einfache Weise sichergestellt werden.

Beispielsweise ist das Sperrelement nur durch eine Bewegung in einer vorgegebenen lateralen Richtung und/oder Drehrichtung entfernbar, und wobei Art, Länge und/oder mechanischer Widerstand dieser Bewegung so bemessen sind, dass das Entfernen des Sperrelements mit einer vorgegebenen Ausstattung an Werkzeug mindestens bis zum Übergang in den berührungssicheren Zustand andauert. Die Aufnahme wirkt dabei mit dem Sperrelement derart zusammen, dass eine bestimmte Bewegung oder eine Kombination aus Bewegungen benötigt wird, um das Sperrelement zu deaktivieren. Durch entsprechendes Auslegen der entsprechenden Faktoren kann eine Zeit vorgegeben werden, die wenigstens gebraucht wird, um das Sperrelement zu entsperren. Dadurch wird eine ausreichende Zeit zum beispielsweise Entladen von Kondensatoren sichergestellt.

In einer weiteren bevorzugten Ausführung der Erfindung verhindert nach Deaktivieren aller Sperrelemente, ein Teil des Schutzdeckels in eine Ebene des Gehäusedeckels ragt, so dass ein Zusammenbau der Hochvolt-Vorrichtung und damit eine erneute bestimmungsgemäße Inbetriebnahme des zu schützenden elektrischen Anschlussklemme, bis alle Sperrelemente aktiviert sind. Dies bedeutet, dass beispielsweise die Sperrelemente, ein letztes zu aktivierendes Sperrelement oder ein anderer Teil des Abdeckmittels nach einer Deaktivierung einen bestimmungsgemäßen Gebrauch verhindert. Dadurch wird sichergestellt, dass alle Sperrelemente bei einer erneuten Inbetriebnahme der mit diesem Abdeckmittel ausgestatteten Vorrichtung aktiviert wurden, so dass ein dauerhafter Schutz gewährleistet werden kann.

Vorzugsweise weist das Abdeckmittel wenigstens ein Verbindungsmittel auf, so dass das Abdeckmittel beweglich an der elektrischen Anschlussklemme oder in einer Umgebung des elektrischen Bereiches befestigbar ist. Das bewegliche Verbindungsmittel ermöglicht dabei sowohl einen Zugang zu der elektrischen Anschlussklemme, wenn dieses nicht mehr geschützt werden muss, als auch eine Position, bei welcher die elektrischen Anschlussklemme vor Berührung geschützt ist. Zusätzlich ist das Abdeckmittel dauerhaft an einem vorbestimmten Platz angeordnet, so dass dieses bei gewöhnlicher Verwendung weder entfernt werden kann noch verloren geht.

In einer vorteilhaften Weiterbildung bildet das Verbindungsmittel ein Scharnier aus, so dass der Schutzdeckel schwenkbar angeordnet ist. Ein Scharnier ist ein einfaches Mittel, mit welchem die Abdeckung dauerhaft an einen bestimmungsgemäßen Platz befestigbar ist.

Erfindungsgemäß ist das Sperrelement verliersicher an dem Schutzdeckel angeordnet oder mit diesem verbunden. Unter verliersicher im Sinne der Erfindung wird verstanden, dass bei einem bestimmungsgemäßen Gebrauch des Abdeckmittels das Sperrelement nicht abhandenkommen kann. Dadurch wird sichergestellt, dass eine Funktion des Sperrelementes dauerhaft gewährleistet werden kann. Dies ermöglicht somit eine sichere Benutzung des Abdeckmittels.

Erfindungsgemäß ist das Sperrelement eine Schraube, welche in Schraubenaxialrichtung an dem Schutzdeckel gehalten ist. Eine Schraube ist dabei ein einfaches und wirtschaftliches Mittel mit welchem sowohl eine Zeitfunktion als auch eine Sperrfunktion ermöglicht wird. Es sind jedoch auch andere Sperrelemente wie beispielsweise Schnapphacken oder eine Führungskulisse möglich, für deren Entsperrung wenigstens eine gewisse Zeit benötigt wird.

Ausführungsbeispiele der Erfindung sind in der Zeichnung dargestellt und in der nachfolgenden Beschreibung näher erläutert. Es zeigt:
- Figur 1: Ausführungsbeispiel einer Hochvolt-Vorrichtung zum Betreiben einer Hochvoltanwendung,
- Figur 2: Hochvolt-Vorrichtung nach Figur 1, nach einem Lösen von den den Gehäusedeckel befestigenden Gehäuseschrauben,
- Figur 3: Hochvolt-Vorrichtung nach einem vollständigen Abnehmen des Gehäusedeckels,
- Figur 4: Hochvolt-Vorrichtung mit einem Abdeckmittel nach einem Lösen des Sperrelementes,
- Figur 5: Hochvolt-Vorrichtung in einer Zugangsposition des Abdeckmittels, und
- Figur 6: Hochvolt-Vorrichtung nach einem regelgerechten Schließen des Abdeckmittels.

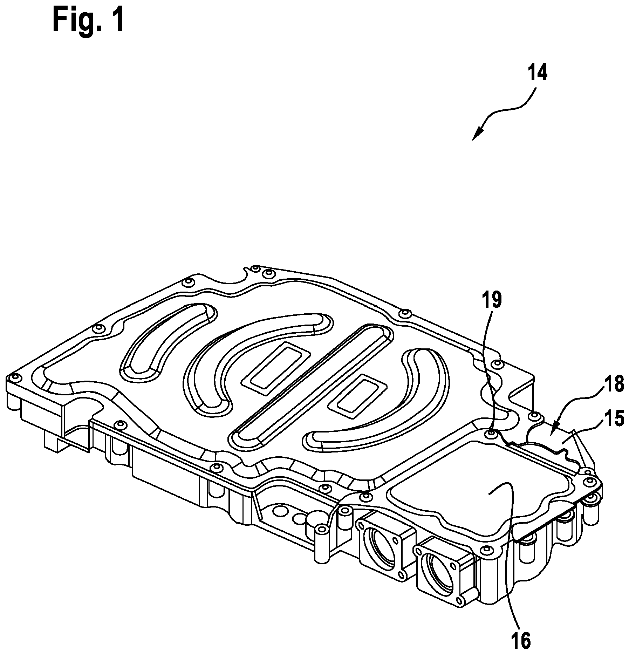

In Figur 1 ist ein Ausführungsbeispiel einer Hochvolt-Vorrichtung 14 zum Betreiben einer Hochvoltanwendung gezeigt. Die Hochvolt-Vorrichtung 14 umfasst ein elektrisch isolierendes Gehäuse 15 und einen Gehäusedeckel 16, welcher in dieser Figur noch an dem Gehäuse 15 befestigt ist. Der Gehäusedeckel 16 deckt ein Gehäuseinneres 18 des elektrisch isolierenden Gehäuses 15 ab.

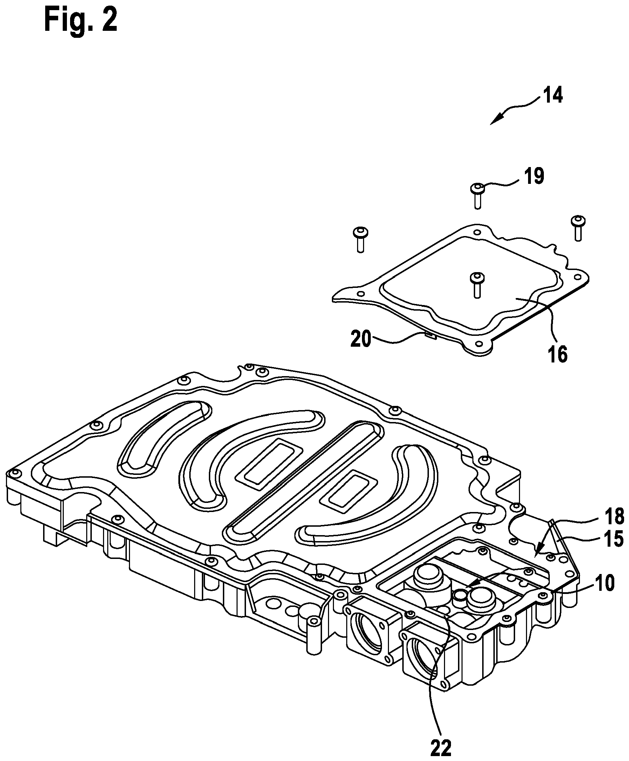

Figur 2 zeigt die Hochvolt-Vorrichtung 14 nach einem Lösen von den den Gehäusedeckel 16 befestigenden Gehäuseschrauben 19. Der hier gezeigte Gehäusedeckel 16 wurde bereits von dem Gehäuse 15 abgenommen. Mit dem Abnehmen des Gehäusedeckels 16 wird eine Kontaktbrücke 20, welche rückseitig an dem Gehäusedeckel 16 angeordnet ist, aus einem Steckkontakt 22 im Gehäuseinneren 18 gezogen, so dass der Steckkontakt 22 geöffnet wird. Über den Steckkontakt 22 wird ein elektrisches Signal erzeugt, so dass eine elektrische Verbindung zu einer Batterie getrennt wird. Durch das Öffnen der elektrischen Verbindung entladen sich Kondensatoren (nicht gezeigt) der Hochvolt-Vorrichtung 14. Das Entladen der Kondensatoren nimmt jedoch eine gewisse Zeit in Anspruch. Um diese Zeit zu gewährleisten, ist ein Abdeckmittel 10 vorgesehen.

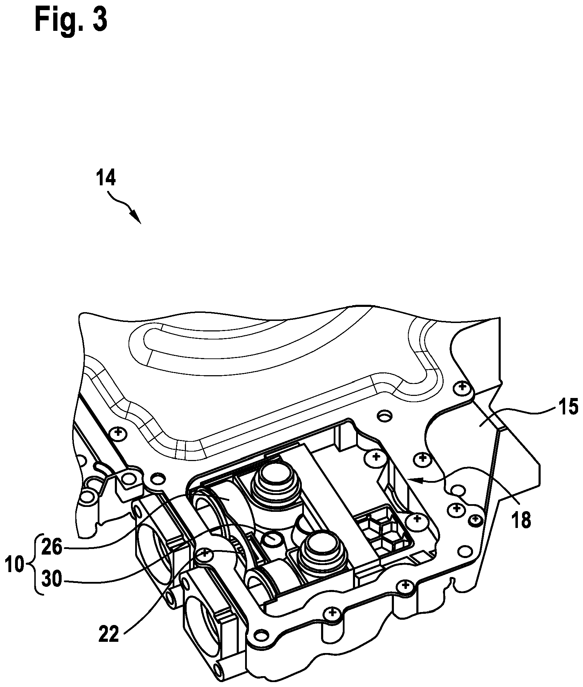

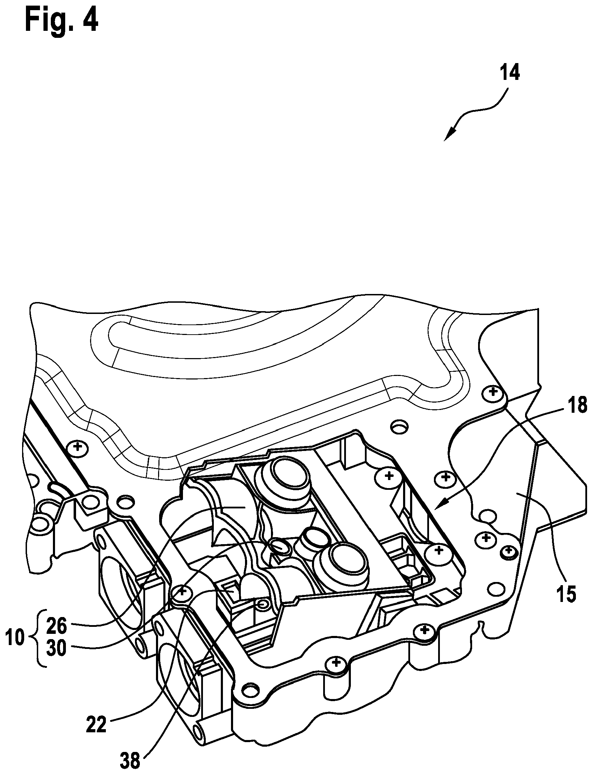

Figur 3 zeigt die Hochvolt-Vorrichtung 14 nach einem vollständigen Abnehmen des Gehäusedeckel 16. Das in dem Ausführungsbeispiel gezeigte Abdeckmittel 10 weist einen Schutzdeckel 26 und ein Sperrelement 30 auf. In der in Figur 3 gezeigten Stellung des Abdeckmittels 10 ist das Sperrelement 30 verriegelt. In diesem Ausführungsbeispiel ist das Sperrelement 30 eine Schraube. Die Schraube 30 ist dabei an dem Schutzdeckel 26 angeordnet und befestigt den Schutzdeckel 26 über einer zu schützenden elektrischen Anschlussklemme 34 (siehe Figur 4).

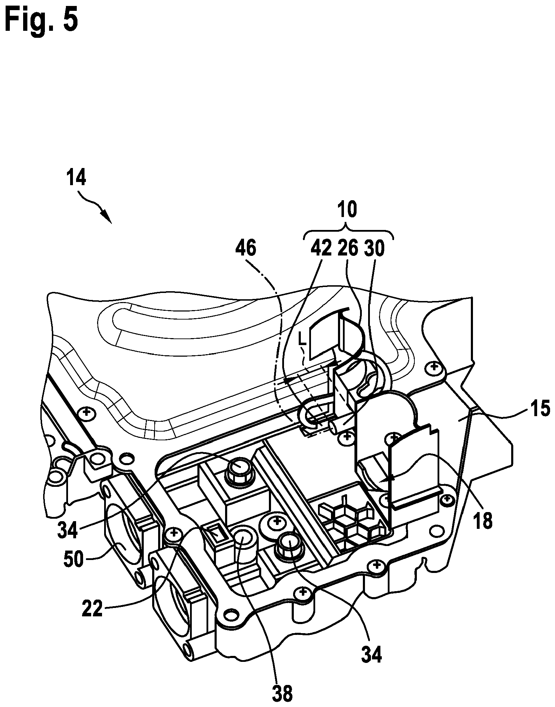

In Figur 4 ist die Hochvolt-Vorrichtung 14 mit dem Abdeckmittel 10 nach einem Lösen des Sperrelementes 30 gezeigt. In dieser Position ist die Schraube 30 aus einer Gewindebohrung 38 herausgeschraubt worden. Dieser Schraubvorgang dauert dabei aufgrund einer entsprechenden Länge L (siehe Figur 5) der Schraube 30 wenigstens eine gewisse Zeit, so dass die zu schützende Anschlussklemme 34, welches hier elektrische Kontakte sind, nicht mehr gegen Berührung geschützt werden muss. Dies bedeutet, dass nach dieser Zeit die Kondensatoren derart entladen sind, dass ein gefahrloses Berühren möglich ist.

In Figur 5 ist die Hochvolt-Vorrichtung 14 in einer Zugangsposition des Abdeckmittels 10 gezeigt. Nach dem Lösen der Schraube 30 kann der Schutzdeckel 26 über ein Verbindungsmittel 42, welche hier Scharniere des Abdeckmittels 10 sind, in die Zugangsposition bewegt werden. Die Scharniere 42 sind dabei in einer Umgebung der elektrischen Anschlussklemmen 34 befestigt, so dass der Schutzdeckel 26 in eine Zugangsposition geschwenkt werden kann. In dieser Position ist eine Raststellung vorgesehen, so dass die Zugangsposition gehalten werden kann. Dadurch wird ein Zugang zu der elektrischen Anschlussklemme 34 vereinfacht.

Die Schraube 30 ist an dem Schutzdeckel 26 verliersicher angeordnet. Dies bedeutet, dass die Schraube 30 bei einer Drehbewegung im Wesentlichen keine Bewegung in Schraubenaxialrichtung 46 in Bezug auf den Schutzdeckel 26 durchführt. In dieser Zugangsposition können elektrische Leitungen (nicht gezeigt) in Öffnungen 50 des Gehäuses 15 eingebracht werden und mit den elektrischen Anschlussklemmen 34 kontaktiert werden.

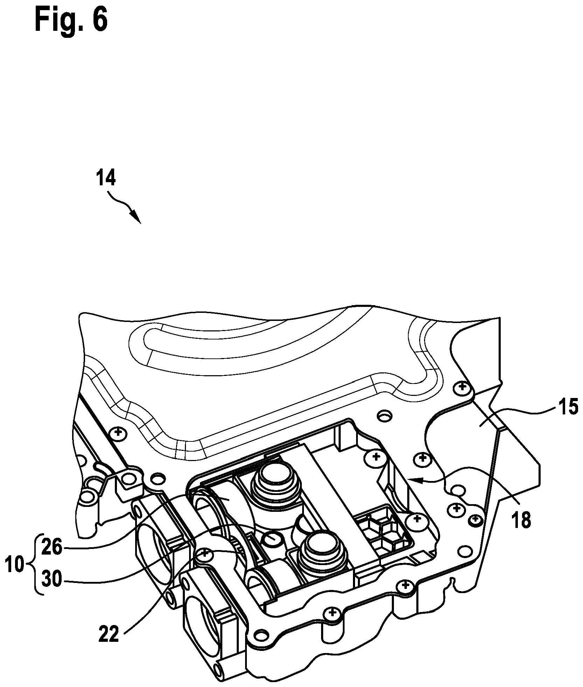

Figur 6 zeigt die Hochvolt-Vorrichtung 14 nach einem regelgerechten Schließen des Abdeckmittels 10. Nach einem Kontaktieren der elektrischen Leitungen, kann der Schutzdeckel 26 wieder in eine Position gebracht werden, bei welcher dieser die elektrischen Anschlussklemmen 34 überdeckt.

Sollte die Schraube 30 in dieser Position nicht wieder eingeschraubt werden, d.h. das Sperrelement 30 aktiviert werden, liegt die Schraube 30 auf der Gewindebohrung 38 auf. Dadurch weist der Schutzdeckel 26 einen zusätzlichen Abstand zu dem zu den elektrischen Anschlussklemmen 34 auf (siehe auch Figur 4), im Vergleich zu einer Position, bei welcher die Schraube 30 eingeschraubt ist. Aufgrund der Tatsache, dass die Schraube 30 keine Bewegung in Schraubenaxialrichtung 46 in Bezug auf den Schutzdeckel 26 durchführt, entspricht dieser Abstand dabei der Länge L der Schraube 30. Dadurch ragt ein Teil des Schutzdeckels 30, wie in Figur 4 gezeigt, in eine Ebene des Gehäusedeckels 16, welcher oberhalb des Schutzdeckels 26 angebracht wird. Dadurch ist kein Zusammenbau der Hochvolt-Vorrichtung 14 möglich und dementsprechend wird die Kontaktbrücke 20 nicht dem Steckkontakt 22 kontaktiert. Eine Inbetriebnahme der Hochvolt-Vorrichtung 14 ist dadurch ebenfalls nicht möglich. Um einen Zusammenbau zu ermöglichen ist somit ein Einschrauben der Schraube 30, und damit ein Aktivieren des Sperrelementes 30, notwendig.

Erst nachdem die Schraube 30 vollständig eingeschraubt wurde, kann der Gehäusedeckel 16 aufgebracht werden, so dass eine sichere Verwendung gewährleistet werden kann. Mit dem Anbringen des Gehäusedeckels 16 wird der Steckkontakt 22 über die Kontaktbrücke 20 wieder geschlossen, sodass die elektrische Verbindung zu der Batterie wieder hergestellt wird.

## Patentansprüche

1. Hochvolt-Vorrichtung (14) für eine Hochvoltanwendung, umfassend ein elektrisch isolierendes Gehäuse (15) mit einem ein Gehäuseinneres (18) abdeckenden Gehäusedeckel (16) und im Gehäuseinneren (18) angeordnete Abdeckmittel (10) für wenigstens eine vor Berührung zu schützende elektrische Anschlussklemme (34) oder elektrischen Bereich, wobei die Abdeckmittel (10) einen die elektrische Anschlussklemme (34) oder den elektrischen Bereich abdeckenden Schutzdeckel (26) aufweisen, der durch mindestens ein Sperrelement (30) in einer geschlossenen Position arretierbar ist und durch einen Öffnungsvorgang in eine geöffnete Position überführbar ist,
**dadurch gekennzeichnet, dass**
das mindestens eine Sperrelement (30) für den gehäuseinneren Schutzdeckel (26) eine Schraube ist, welche in Schraubenaxialrichtung (46) an dem Schutzdeckel (26) gehalten und verliersicher an dem Schutzdeckel (26) angeordnet ist, wobei dessen Lösen über einen Schraubvorgang aufgrund einer entsprechend Länge (L) der Schraube eine Zeitdauer beansprucht, nach welcher ab dem Öffnen des Gehäusedeckels (16) und damit ausgelöster Unterbrechung des Hochvolt-Stromkreises die elektrische Anschlussklemme (34) oder der elektrische Bereich in einen berührungssicheren Zustand übergegangen ist.

2. Hochvolt-Vorrichtung (14) nach Anspruch 1, **dadurch gekennzeichnet, dass** nach Deaktivieren aller Sperrelemente (30), ein Teil des Schutzdeckels (26) in eine Ebene des Gehäusedeckels (16) ragt, so dass ein Zusammenbau der Hochvolt-Vorrichtung (14) und damit eine erneute bestimmungsgemäße Inbetriebnahme der zu schützenden elektrischen Anschlussklemme (34) verhindert ist, bis alle Sperrelemente (30) aktiviert sind.

3. Hochvolt-Vorrichtung (14) nach einem der vorherigen Ansprüche, **dadurch gekennzeichnet, dass** das Abdeckmittel (10) wenigstens ein Verbindungsmittel (42) aufweist, so dass das Abdeckmittel (10) beweglich an der elektrischen Anschlussklemme (34) oder in einer Umgebung des elektrischen Bereiches befestigbar ist.

4. Hochvolt-Vorrichtung (14) nach Anspruch 3, **dadurch gekennzeichnet, dass** das Verbindungsmittel (42) ein Scharnier ausbildet, so dass der Schutzdeckel (26) schwenkbar angeordnet ist.

## Claims

1. High-voltage device (14) for a high-voltage application, comprising an electrically insulating housing (15) having a housing cover (16) which covers a housing interior (18) and cover means (10), arranged in the housing interior (18), for at least one electrical terminal (34) or electrical area to be protected from touch, wherein the cover means (10) have a protective cover (26), which covers the electrical terminal (34) or the electrical area, can be locked in a closed position by means of at least one locking element (30) and can be transferred into an open position by means of an opening procedure, **characterized in that** the at least one locking element (30) for the protective cover (26) within the housing is a screw, which is held on the protective cover (26) in the axial screw direction (46) and is arranged on the protective cover (26) in a loss-proof manner, wherein its release over a screwing procedure owing to a corresponding length (L) of the screw demands a period of time, after which the electrical terminal (34) or the electrical area has transitioned to a touch-proof state following the opening of the housing cover (16) and the thus-triggered interruption of the high-voltage circuit.

2. High-voltage device (14) according to Claim 1, **characterized in that**, after the deactivation of all locking elements (30), part of the protective cover (26) projects into a plane of the housing cover (16) so that the high-voltage device (14) is prevented from being assembled and therefore designated operation of the electrical terminal (34) to be protected is prevented from commencing again until all locking elements (30) are activated.

3. High-voltage device (14) according to either of the preceding claims, **characterized in that** the cover means (10) has at least one connecting means (42) so that the cover means (10) can be movably fastened on the electrical terminal (34) or in the vicinity of the electrical area.

4. High-voltage device (14) according to Claim 3, **characterized in that** the connecting means (42) forms a hinge so that the protective cover (26) is pivotably arranged.

## Revendications

1. Dispositif à haute tension (14) destiné à une application à haute tension, comprenant un boîtier (15) électriquement isolant pourvu d'un couvercle de boîtier (16) recouvrant l'intérieur du boîtier (18) et des moyens de recouvrement (10) disposés à l'intérieur du boîtier (18) pour au moins une borne de connexion électrique (34) ou un secteur électrique à protéger contre le contact, dans lequel les moyens de recouvrement (10) présentent un couvercle de protection (26) recouvrant la borne de connexion électrique (34) ou le secteur électrique et qui peut être bloqué par au moins un élément de verrouillage (30) dans une position fermée et peut être amené dans une position ouverte par un processus d'ouverture,
**caractérisé en ce que** ledit au moins un élément de verrouillage (30) pour le couvercle de protection (26) à l'intérieur du boîtier est une vis qui est maintenue dans la direction axiale de vis (46) sur le couvercle de protection (26) et est disposée de manière imperdable sur le couvercle de protection (26), dans lequel le desserrage de celui-ci par un processus de vissage prend un certain temps selon la longueur (L) de la vis après lequel, à compter de l'ouverture du couvercle de boîtier (16) et donc d'une interruption déclenchée du circuit électrique à haute tension, la borne de connexion électrique (34) ou le secteur électrique est passé(e) à un état protégé contre le contact.

2. Dispositif à haute tension (14) selon la revendication 1, **caractérisé en ce qu'**après la désactivation de tous les éléments de verrouillage (30), une partie du couvercle de protection (26) fait saillie dans un plan du couvercle de boîtier (16) de sorte qu'un assemblage du dispositif à haute tension (14) et donc une remise en service conforme de la borne de connexion électrique (34) à protéger est empêchée jusqu'à ce que tous les éléments de verrouillage (30) aient été activés.

3. Dispositif à haute tension (14) selon l'une quelconque des revendications précédentes, **caractérisé en ce que** le moyen de recouvrement (10) présente au moins un moyen de liaison (42) de sorte que le moyen de recouvrement (10) peut être fixé de manière mobile à la borne de connexion électrique (34) ou dans un environnement du secteur électrique.

4. Dispositif à haute tension (14) selon la revendication 3, **caractérisé en ce que** le moyen de liaison (42) réalise une charnière de sorte que le couvercle de protection (26) est disposé de manière pivotante.
